# EUROPÄISCHE PATENTANMELDUNG

(11) **EP 3 244 227 A1**
(43) Veröffentlichungstag der Anmeldung: **15.11.2017**
(21) Anmeldenummer: 17169521.6
(22) Anmeldetag: 04.05.2017
(51) Int. Cl.: G01R 33/30, G01R 33/28, G01R 33/62, G01N 24/12

(54) **MAS-STATOR EINES NMR-PROBENKOPFES MIT OPTIMIERTER MIKROWELLENEINSTRAHLUNG**

(30) Priorität: 10.05.2016 DE 102016207998
(71) Anmelder: Bruker BioSpin GmbH, 76287 Rheinstetten (DE)
(72) Erfinder: Purea, Armin, 76669 Bad Schönborn (DE); von Bieren, Arndt, 81829 München (DE)
(74) Vertreter: Kohler Schmid Möbus Patentanwälte

(57) **Zusammenfassung**

Ein MAS-Stator (1) eines NMR-Probenkopfes mit Zuführung von Mikrowellenstrahlung durch eine Öffnung in einem Spulenklotz (2) in das Probenvolumen (4), wobei eine Mikrowellenlinse (6) vorgesehen ist, wobei der MAS-Rotor (3) von einer solenoidförmigen HF-Spule (5) umgeben ist, und wobei auf der Innenseite des MAS-Stators ein Mikrowellenspiegel (8a) vorhanden ist, ist dadurch gekennzeichnet, dass die Mikrowellenlinse in der Öffnung des Spulenklotzes auf der Probenvolumen-zugewandten Seite derart angeordnet und ausgebildet ist, dass die Zylinderachse des MAS-Rotors im Brennpunkt der Mikrowellenlinse liegt, dass die HF-Spule eine aus beabstandeten Windungen aufgebaute einlagige Solenoidspule ist, aufgrund deren Windungsdrahtdicke d und Windungsabstand D die Mikrowellenstrahlung zu mindestens 80% transmittiert wird, wobei das Verhältnis d:D ≤ 0,5 und das Verhältnis von D zur Wellenlänge der Mikrowellenstrahlung im Vakuum > 0,5 ist, dass der Mikrowellenspiegel auf oder in der dem Mikrowellenleiter (9) gegenüberliegenden Innenwand des MAS-Stators angeordnet, zylindrisch und konkav aufgebaut ist, und dass der Mikrowellenspiegel die vom Probenvolumen auftreffende Mikrowellenstrahlung auf die Mittelachse des MAS-Rotors fokussiert. Damit wird die Einstrahleffizienz (=magnetische Feldstärke pro eingestrahlter Leistungseinheit) im MAS-Rotor am Ort der Probe in einem bei der DNP-Technik für die Anregung der Elektronenspins typischen Frequenzbereich (200-600 GHz) erheblich verbessert.

## Beschreibung

Die Erfindung betrifft einen MAS-Stator eines NMR-Probenkopfes, insbesondere eines NMR-DNP-MAS-Probenkopfes zur Aufnahme eines im Wesentlichen kreiszylindrischen hohlen MAS-Rotors mit einer Probensubstanz in einem Probenvolumen, welcher in einer Messposition innerhalb des MAS-Stators mittels einer Einrichtung zur Gaszufuhr druckgasgelagert sowie mittels eines pneumatischen Antriebs in Rotation um die Zylinderachse des MAS-Rotors versetzt werden kann, wobei ein hohler Mikrowellenleiter zur Zuführung von Mikrowellenstrahlung durch eine Öffnung in einem in die Wand des MAS-Stators eingeführten Spulenklotzes in das Probenvolumen vorgesehen ist, wobei zwischen dem Mikrowellenleiter und dem Probenvolumen eine Mikrowellenlinse zur Bündelung der zugeführten Mikrowellenstrahlung auf den MAS-Rotor angeordnet ist, wobei der MAS-Rotor von einer solenoidförmigen HF-Spule umgeben ist, und wobei auf der dem Mikrowellenleiter gegenüberliegenden Innenseite des MAS-Stators ein Mikrowellenspiegel zur Reflexion der aus dem Mikrowellenleiter austretenden und durch das Probenvolumen hindurchtretenden Mikrowellenstrahlung vorhanden ist.

Ein solcher MAS-Stator ist bekannt aus der WO 2015/175507 A1.

### Hintergrund der Erfindung

Die vorliegende Erfindung betrifft allgemein den Bereich der Magnetresonanz (MR). Kernspinresonanz(NMR)-Spektroskopie ist eine kommerziell weit verbreitete Methode der MR zur Charakterisierung der chemischen Zusammensetzung von Substanzen. Generell werden bei der MR Hochfrequenz(=HF)-Pulse in die Messprobe, die sich in einem starken statischen Magnetfeld befindet, eingestrahlt, und die elektromagnetische Reaktion der Probe wird vermessen. Bei der Festkörper NMR-Spektroskopie ist es weiter bekannt, zur Verringerung von Linienverbreiterungen aufgrund anisotroper Wechselwirkungen eine NMR-Probe während der spektroskopischen Vermessung unter dem so genannten "Magischen Winkel" von ca. 54,74° gegenüber dem statischen Magnetfeld verkippt rotieren zu lassen ("MAS" = Magic Angle Spinning). Dazu wird die Probe in einen MAS-Rotor gefüllt. MAS-Rotoren sind zylindrische Röhrchen, die mit einer oder zwei Kappen verschlossen sind, wobei die obere mit Flügelelementen («Schaufelrädchen») versehen ist. Der MAS-Rotor wird in einem MAS-Stator angeordnet, und mit Gasdruck wird der MAS-Rotor über die Flügelelemente für die Rotation angetrieben. Die Gesamtheit aus MAS-Rotor und MAS-Stator wird MAS-Turbine genannt.

Während der NMR-Messung ist die MAS-Turbine in einem NMR-MAS-Probenkopf angeordnet. Der Probenkopf verfügt über ein zylindrisches Abschirmrohr. Darin sind HF-Elektronikbauteile, insbesondere HF- Spulen, und die MAS-Turbine untergebracht. Der Probenkopf wird mit seinem Abschirmrohr typischerweise von unten in die vertikale Raumtemperatur-bohrung eines supraleitenden Magneten eingeführt, positioniert, und mit Haken, Stützen, Schrauben oder dergleichen gehalten. Die MAS-Turbine befindet sich dann genau im magnetischen Zentrum des Magneten.

Zusätzlich zur Festkörper-NMR kann auch die Technik des dynamischen Transfers der Spin-Polarisation (DNP= Dynamic Nuclear Polarization) eingesetzt werden. Die DNP-Technik erfordert die gleichzeitige Einstrahlung eines magnetischen Mikrowellenfeldes auf einer Frequenz, die um den Faktor 660 höher als die Larmor-Frequenz der 1 H Kerne ist. Durch Einstrahlung eines Mikrowellenfeldes in geeigneter Frequenz werden Elektronenspins angeregt, wonach aufgrund von Spin-Wechselwirkungen ein Transfer der Elektronenpolarisation auf die Atomkerne der Probe bewirkt werden kann.

### Spezieller Stand der Technik

Derzeit erfolgt üblicherweise eine simple Mikrowellen-Einstrahlung in den MAS-Stator durch ein rundes Loch im Spulenklotz durch die HF-Spule, gegebenenfalls mit einer geeigneten Aufweitung der Spulenwindungen im Zentrum ohne weitere Maßnahmen. Dadurch gelangt jedoch nur ein Bruchteil der eingebrachten Leistung ins magnetische Wechselfeld am Ort der Probe.

In der Publikation Nanni et al., Journal of Magnetic Resonance 210 (1), 2011, 16-2 sind einzelne Bestandteile einer gattungsgemäßen Apparatur wie Linse, Spulenwindungen, Rotorwanddicke, Spiegel etc. zwar per se beschrieben, aber nicht in einer geeigneten Kombination und mit gemeinsamer Optimierung. Des Weiteren fehlt eine Betrachtung der Tunebarkeit auf verschiedene Proben.

In der WO 2015/107512 A1 geht es ebenfalls um eine Steigerung des Millimeterwellen-Feldes für DNP, allerdings statisch, also nicht-rotierend. Die MAS-Technik wird nur als weiteres Ziel erwähnt. Außerdem kommt hier auch keine Linse zum Einsatz, sondern eine resonator-ähnliche Struktur.

Die eingangs zitierte WO 2015/175507 A1 hingegen beschreibt bereits eine gattungsgemäße Anordnung mit den eingangs definierten Merkmalen. Die in Fig. 10C gezeigte Feldverteilung impliziert, dass die bekannte Anordnung einen abstimmbaren Resonator erzeugt. Der dort gezeigte verstellbare Spiegel soll eine "cavity mode" abstimmen. Weiterhin sieht man in Fig. 10C der Druckschrift, dass die Wellenlänge etwa dem doppelten Rotordurchmesser entspricht. Das bedeutet für ein 3,2mm-System eine Vakuumwellenlänge von etwa 6mm und damit eine Frequenz von 50GHz. Eigentlich würde diese sogar in der Materie verkürzt, so dass die Darstellung in Fig. 10C also unphysikalisch ist, sobald der Rotor und die Messprobe eine dielektrische Konstante >1 besitzen, wovon man üblicherweise ausgehen kann.

Während solch eine stark resonante Struktur den Vorteil hoher Feldamplitude besitzt, liegt ein grundsätzlicher Nachteil von derartigen Resonatoren darin, dass die üblicherweise hohe erzielbare Güte eine sehr schmale Frequenzbandbreite bedingt, die sehr empfindlich auf äußere oder innere Einflüsse reagiert und somit eine sehr präzise Abstimmung erfordert.

### Aufgabe der Erfindung

Der vorliegenden Erfindung liegt demgegenüber die Aufgabe zugrunde, einen MAS-Stator für einen NMR-DNP-MAS-Probenkopf der eingangs definierten Art zur Verfügung zu stellen, der eine wesentliche Verbesserung der Einstrahleffizienz, also der magnetischen Feldstärke pro eingestrahlter Leistungseinheit, im MAS-Rotor des Probenkopfes am Ort der Probe in einem bei der DNP-Technik für die Anregung der Elektronenspins typischen Frequenzbereich (in der Regel 200-600 GHz) bewirkt.

### Kurze Beschreibung der Erfindung

Diese Aufgabe wird gelöst durch einen MAS-Stator der eingangs genannten Art, der dadurch gekennzeichnet ist, dass die Mikrowellenlinse in der Öffnung des Spulenklotzes auf der dem Probenvolumen zugewandten Seite derart angeordnet und hinsichtlich ihrer Brennweite geometrisch so ausgebildet ist, dass die Zylinderachse des MAS-Rotors im Brennpunkt der Mikrowellenlinse liegt, dass die Mikrowellenlinse geometrisch so ausgebildet ist, dass ihre Dicke auf ihrer Mittelachse ein ganzzahliges Vielfaches der halben Wellenlänge der transmittierten Mikrowellenstrahlung im Dielektrikum des Mikrowellenleiters beträgt, so dass die aus dem Mikrowellenleiter ankommende Mikrowellenstrahlung maximal in Richtung auf das Probenvolumen transmittiert wird, dass die HF-Spule eine aus mehreren voneinander beabstandeten Windungen aufgebaute einlagige Solenoidspule ist, deren Windungsdrahtdicke d und Windungsabstand D so optimiert sind, dass die Mikrowellenstrahlung durch die HF-Spule zu mindestens 80% transmittiert wird, wobei das Verhältnis von d zu D gleich oder kleiner als 0,5 und das Verhältnis von D zur Wellenlänge der Mikrowellenstrahlung im Vakuum größer als 0,5, vorzugsweise im Bereich von 1, ist, dass der Mikrowellenspiegel auf oder in der dem Mikrowellenleiter bezüglich des Probenvolumens gegenüberliegenden Innenwand des MAS-Stators angeordnet und zylindrisch sowie in Richtung auf das Probenvolumen konkav aufgebaut ist, und dass der Mikrowellenspiegel konstruktiv derart ausgestaltet ist, dass er die vom Probenvolumen kommend auf ihn auftreffende Mikrowellenstrahlung auf die Mittelachse des kreiszylindrischen MAS-Rotors fokussiert.

Mit der vorliegenden Erfindung wird ein Stator für die NMR-DNP-MAS-Spektroskopie bereitgestellt, der eine bessere Ausbeute der einfallenden Mikrowellenleistung ermöglicht, indem mehrere Komponenten geeignet kombiniert werden. Durch die Linse wird der Strahl nicht nur auf die Probe fokussiert, sondern gleichzeitig senkrecht auf die gekrümmte Rotoroberfläche gebracht. Dadurch wird der optische Weg durch die Rotorwand für den gesamten Strahl gleich lang, so dass die Dicke der Rotorwand so eingestellt werden kann, dass ein möglichst großer Teil der Strahlung transmittiert wird. Die Spule ist in dieser Hinsicht eine störende Komponente, da sie je nach Ausführung zur Beugung und Streuung des Strahls führen kann. Zur Beibehaltung der Strahlcharakteristik wird die Spule daher in oben genannter Weise dimensioniert, so dass auch nach mehreren Durchgängen durch die Spule keine nennenswerte Streuung oder Beugung stattfindet. Platziert man noch einen Spiegel an die Stator-Rückwand, ebenfalls so dass sein Brennpunkt im Zentrum des Rotors liegt, dann erreicht man einen erneuten Durchgang des Strahls durch die Probe, wodurch ein größerer Anteil der eingebrachten Leistung in der Probe wirken kann.

Im Unterschied zum oben diskutierten Stand der Technik versucht die vorliegende Erfindung, mit einem quasioptischen Aufbau eine geschickte Bündelung der Mikrowellenstrahlung auf die Probe zu erreichen und dabei die Strahlcharakteristik so zu erhalten, dass nach Reflexion an einem geeigneten Spiegel ein zweiter Durchgang durch die Probe ermöglicht wird. In dieser Hinsicht ist der vorliegende erfindungsgemäße Aufbau als nur schwach resonante Struktur einzuordnen. Er ist daher aber auch robuster.

### Weitere Vorteile gegenüber dem Stand der Technik:

Der entscheidende Vorteil der erfindungsgemäßen Merkmalskombination liegt darin, dass jede einzelne Verbesserung ihren Beitrag überhaupt leisten kann. Wählt man nicht die mit der Erfindung vorgeschlagene Kombination, dann kann es sein, dass ein einzelnes Merkmal gar nicht sein volles Potential entfalten kann. Ein Beispiel wäre etwa der Spiegel: Ohne eine geeignete Linse, eine angepasste Spule und eine angepasste Rotorwand wird kaum etwas von der Strahlung durch die Probe zurückgeworfen, da der Strahl zu stark gestreut und in ungünstiger Weise reflektiert wird.

Ein weiterer Vorteil der vorliegenden Erfindung liegt darin, dass der vorhandene, marktübliche MAS-Stator kaum modifiziert werden muss und die Zusatzteile nur einen sehr geringen einen Materialaufwand erfordern, so dass die erfindungsgemäße Lehre äußerst kostengünstig verwirklicht werden kann.

### Bevorzugte Ausführungsformen und Weiterbildungen der Erfindung

Bei besonders bevorzugten Ausführungsformen des erfindungsgemäßen MAS-Stators ist die Mikrowellenlinse in Strahlungsrichtung der aus dem Mikrowellenleiter in Richtung auf das Probenvolumen austretenden Mikrowellenstrahlung gesehen konvex-plan ausgeführt und weist vorzugsweise auf ihrer Mittelachse eine Dicke zwischen 1 mm und 2mm, insbesondere etwa 1,5mm, auf. Damit wird eine Änderung der Einstrahlung auf die Probe dergestalt bewirkt, dass der einfallende Strahl senkrecht auf die Rotorwand trifft, so dass die Rotorwandstärke auf eine optimale Transmission eingestellt werden kann (wie eine planare Schicht).

In der Praxis erweisen sich Ausführungsformen der Erfindung als besonders nützlich, bei welchen die Mikrowellenlinse mindestens eine zylindrische Fläche, insbesondere mit einem Krümmungsradius zwischen 8mm und 15mm, vorzugsweise etwa 11,5mm, aufweist. Dadurch wird die Linse als Sammellinse ausgebildet mit verhältnismäßig großem Radius aufgrund der hohen Brechkraft (siehe unten), so dass die Dicke im Vergleich zu den Dimensionen in den anderen beiden Richtung gering ist.

Des Weiteren ist bei bevorzugten Ausführungsformen des erfindungsgemäßen Probenkopfes die Mikrowellenlinse aus dielektrischem Material, vorzugsweise aus Saphir und/oder Silizium und/oder Bornitrid aufgebaut. Diese Materialien bewirken nur geringe Verluste (tan d ≤ 0,001) sowie eine hohe Brechkraft auch für dünne Linsen (siehe oben).

Bevorzugt sind auch Ausführungsformen der Erfindung, bei denen auf den äußeren Oberflächen der Mikrowellenlinse eine Anti-Reflexionsschicht, vorzugsweise aus Kunststoff, insbesondere aus PTFE oder Vespel, oder aus einer sub-Wellenlängen-Struktur, aufgebracht ist. Eine solche Antireflexschicht maximiert die Transmission des einfallenden Strahls durch die Linse.

Eine weitere bevorzugte Ausführungsform sieht vor, dass die HF-Spule aus einem magnetisch kompensierten Draht oder aus Cu und/oder Ag und/oder Al beziehungsweise deren Legierungen aufgebaut ist. Damit werden Feldverzerrungen durch die HF-Spule gering gehalten und eine ausreichend gute spektrale Auflösung (<∼wenige Hz im NMR-Experiment) ermöglicht.

Bevorzugt sind auch Ausführungsformen des erfindungsgemäßen MAS-Stators, bei welchen die HF-Spule mit einer Windungsdrahtdicke d von 0,2mm bis 0,5mm, insbesondere d ∼ 0,3mm, mit 5 bis 10 Windungen, insbesondere 7,5 Windungen, und mit einem Windungsabstand D von 0,7mm bis 2mm, insbesondere D ∼ 1 mm, aufgebaut ist. Dabei handelt es sich um typische Drahtdicken für NMR-Spulen mit ausreichend hoher Empfindlichkeit.

Bei einer Klasse von vorteilhaften Ausführungsformen des erfindungsgemäßen MAS-Stators weist der Mikrowellenspiegel aus Ag, Au oder Cu-Blech aufgebaut ist, welches vorzugsweise eine Dicke zwischen 1 µm und 100µm, insbesondere etwa 70µm, auf. Dünnes Blech aus den genannten Materialien minimiert die statische und HF-Feldverzerrung, während die Mikrowellenstrahlung aufgrund der geringen Skintiefe vollständig reflektiert wird.

Eine weitere Klasse von besonders einfach aufgebauten und kompakten Ausführungsformen der Erfindung zeichnet sich dadurch aus, dass der Mikrowellenspiegel auf der dem Mikrowellenleiter bezüglich des Probenvolumens gegenüberliegenden Innenwand des MAS-Stators starr aufgebracht, insbesondere aufgeklebt, aufgelötet oder aufgeschweißt ist. Auf diese Weise wird der Strahl wieder in das Probenvolumen zurückreflektiert.

In einer dazu alternativen Klasse von Ausführungsformen des erfindungsgemäßen MAS-Stators, die zwar ein wenig aufwändiger in der Herstellung, dafür aber deutlich flexibler in der Handhabung ist, ist der Mikrowellenspiegel verstellbar, insbesondere verschiebbar, in die dem Mikrowellenleiter bezüglich des Probenvolumens gegenüberliegenden Innenwand des MAS-Stators eingebracht. Mit der Verstellung des Abstands zum Rotor kann die Transmission ins Probenvolumen für unterschiedliche dielektrische Konstanten der Probe maximiert werden. Im Unterschied zum Abstimmen der "cavity mode" des nächstliegenden Standes der Technik ist es hier jedoch so, dass selbst in der ungünstigsten Position des Spiegels eine Feldstärke in der Probe erreicht wird, die noch dem einfachen Durchgang entspricht. Die Gefahr eines völligen Verstimmens besteht also nicht.

Vorteilhaft ist weiterhin eine Ausführungsform, bei der der MAS-Stator zur Einstellung des MAS-Winkels drehbar gelagert ist. Durch die Drehbarkeit des Stators im Probenkopf kann bei begrenztem Raum das Ein- und Ausführen des MAS-Rotors weiter erleichtert werden; enge Kurven werden vermieden. Durch die Drehbarkeit des Stators kann zum Ein- und Ausschleusen der Winkel der Stator-Lagerachse gegenüber der Längserstreckungsrichtung des Rohres (die regelmäßig zumindest in guter Näherung der Richtung des statischen Magnetfelds im NMR-Magneten entspricht) verglichen mit dem magischen Winkel verkleinert werden.

In den Rahmen der vorliegenden Erfindung fällt auch ein Probenkopf mit einem MAS-Stator der oben beschriebenen erfindungsgemäßen Art, bei dem ein pneumatisches Probenwechselsystem mit einer Transportleitung zum Zuführen und Abführen eines MAS-Rotors zum MAS-Stator vorgesehen ist, welches ebenfalls zur Automatisierung der Messvorbereitungen und zum erleichterten Ablauf von MAS-NMR-Experimenten durch Minimierung der Probenwechselzeiten beiträgt.

Die Vorteile der vorliegenden Erfindung kommen in besonders günstiger Weise zum Tragen, wenn bei dem erfindungsgemäßen Probenkopf ein MAS-Rotor mit einem Durchmesser von 0,7mm bis 4mm, vorzugsweise von 1,3mm bis 3,2mm, verwendet wird. In dieser Bandbreite bietet die Anmelderin derzeit Rotoren für gattungsgemäße MAS-DNP-Probenköpfe an.

Bevorzugt ist der hohle MAS-Rotor geometrisch so ausgebildet, dass seine Wanddicke einem ganzzahligen Vielfachen der halben Wellenlänge der transmittierten Mikrowellenstrahlung im Dielektrikum der Rotorwand entspricht, so dass die aus der Mikrowellenlinse ankommende Mikrowellenstrahlung maximal in Richtung auf das Probenvolumen, aus dem Probenvolumen heraus und auf den Mikrowellenspiegel transmittiert. Damit lassen sich eine Minimierung der Reflexion sowie eine Maximierung der Transmission durch die Rotorwand bewirken.

In der Praxis bewähren sich besonders Ausführungsformen des erfindungsgemäßen Probenkopfes, bei welchen der MAS-Rotor aus Saphir, tetragonal stabilisiertem Zirkonoxid und/oder Siliziumnitrid, mit einer Wanddicke zwischen 0,2mm bis 0,7mm, vorzugsweise etwa 0,3mm und 0,55mm, sowie mit einem Durchmesser kleiner 4mm, insbesondere etwa 3,2mm, etwa 1,9mm oder etwa 1,3mm, aufgebaut ist. Diese Materialien sind für MAS-DNP-NMR besonders geeignet, da sie unmagnetisch sind, ausreichend mechanische Festigkeit besitzen, um den bei der Rotation auftretenden Kräften standzuhalten und man deren Wandstärke in oben genannter Weise auf maximale Transmission einstellen kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:

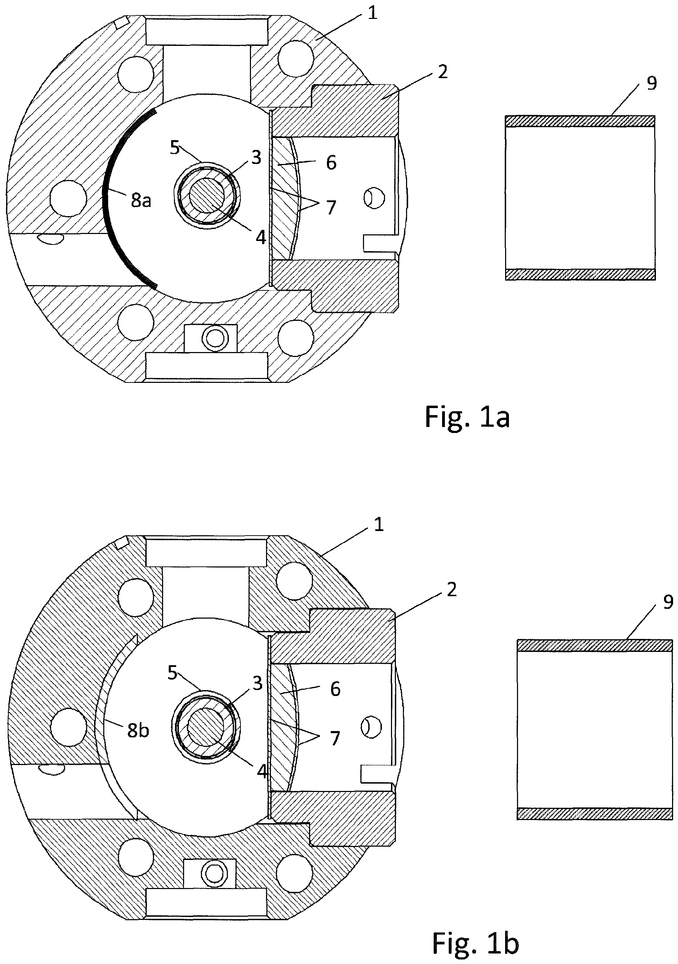

- Fig. 1a: eine schematische Querschnittsdarstellung einer ersten Ausführungsform des erfindungsgemäßen NMR-MAS-Probenkopfs mit an der Stator-Innenwand fest angebrachtem Mikrowellenspiegel;
- Fig. 1 b: eine weitere Ausführungsform der Erfindung mit verstellbarem Mikrowellenspiegel;
- Fig. 2a: eine schematische Querschnittsdarstellung eines NMR-MAS-Probenkopfs gemäß Stand der Technik ohne Mikrowellenlinse und ohne Mikrowellenspiegel;
- Fig. 2b: eine schematische Querschnittsdarstellung eines NMR-MAS-Probenkopfs gemäß dem nächstkommenden Stand der Technik mit plan-konvexer Mikrowellenlinse und flachem Mikrowellenspiegel;
- Fig. 3: ein zentraler Schnitt durch die H-Feldamplitudenverteilung einer 3D EM-Simulation bei einer Anordnung nach dem Stand der Technik (oben) und einer erfindungsgemäßen Anordnung (unten), wobei die Skalierung beider Feldwerte gleich gewählt wurde; und
- Fig. 4: eine Grafik mit experimentellen Ergebnissen.

Die Erfindung betrifft eine neuartige Ausgestaltung eines MAS-Stators für einen MAS-DNP-NMR-Probenkopf und findet ihre Hauptanwendung als Bestandteil einer Magnetresonanz-Apparatur. Die Ausführungsformen der erfindungsgemäßen Anordnung, wie sie in den Figuren 1 a und 1 b dargestellt sind, umfassen jeweils einen **MAS-Stator 1** eines NMR-Probenkopfes zur Aufnahme eines im Wesentlichen kreiszylindrischen hohlen **MAS-Rotors 3** mit einer Probensubstanz in einem **Probenvolumen 4,** welcher in einer Messposition innerhalb des MAS-Stators 1 mittels einer Einrichtung zur Gaszufuhr druckgasgelagert sowie mittels eines pneumatischen Antriebs in Rotation um die Zylinderachse des MAS-Rotors 3 versetzt werden kann, wobei ein hohler **Mikrowellenleiter 9** zur Zuführung von Mikrowellenstrahlung durch eine Öffnung in einem in die Wand des MAS-Stators 1 eingeführten **Spulenklotzes 2** in das Probenvolumen 4 vorgesehen ist, wobei zwischen dem Mikrowellenleiter 9 und dem Probenvolumen 4 eine **Mikrowellenlinse 6** zur Bündelung der zugeführten Mikrowellenstrahlung auf den MAS-Rotor 3 angeordnet ist, wobei der MAS-Rotor 3 von einer solenoidförmigen **HF-Spule 5** umgeben ist, und wobei auf der dem Mikrowellenleiter 9 gegenüberliegenden Innenseite des MAS-Stators 1 ein **Mikrowellenspiegel 8a; 8b** zur Reflexion der aus dem Mikrowellenleiter 9 austretenden und durch das Probenvolumen 4 hindurchtretenden Mikrowellenstrahlung vorhanden ist

Die erfindungsgemäße Anordnung zeichnet sich dadurch aus, dass die Mikrowellenlinse 6 in der Öffnung des Spulenklotzes 2 auf der dem Probenvolumen 4 zugewandten Seite derart angeordnet und hinsichtlich ihrer Brennweite geometrisch so ausgebildet ist, dass die Zylinderachse des MAS-Rotors 3 im Brennpunkt der Mikrowellenlinse 6 liegt.

Die Mikrowellenlinse 6 ist geometrisch so ausgebildet, dass ihre Dicke auf ihrer Mittelachse ein ganzzahliges Vielfaches der halben Wellenlänge der transmittierten Mikrowellenstrahlung im Dielektrikum des Mikrowellenleiters 9 beträgt, so dass die aus dem Mikrowellenleiter 9 ankommende Mikrowellenstrahlung maximal in Richtung auf das Probenvolumen 4 transmittiert wird.

Die HF-Spule 5 ist eine aus mehreren voneinander beabstandeten Windungen aufgebaute einlagige Solenoidspule, deren Windungsdrahtdicke d und Windungsabstand D so optimiert sind, dass die Mikrowellenstrahlung durch die HF-Spule 5 zu mindestens 80% transmittiert wird, wobei das Verhältnis von d zu D gleich oder kleiner als 0,5 und das Verhältnis von D zur Wellenlänge der Mikrowellenstrahlung im Vakuum größer als 0,5 ist, vorzugsweise im Bereich von 1.

Der Mikrowellenspiegel 8a; 8b ist auf oder in der dem Mikrowellenleiter 9 bezüglich des Probenvolumens 4 gegenüberliegenden Innenwand des MAS-Stators 1 angeordnet und zylindrisch sowie in Richtung auf das Probenvolumen 4 konkav aufgebaut. Außerdem ist der Mikrowellenspiegel 8a; 8b konstruktiv derart ausgestaltet, dass er die vom Probenvolumen 4 kommend auf ihn auftreffende Mikrowellenstrahlung auf die Mittelachse des kreiszylindrischen MAS-Rotors 3 fokussiert.

Auf den äußeren Oberflächen der Mikrowellenlinse 6 kann beim erfindungsgemäßen MAS-Stator 1 eine **Anti-Reflexionsschicht 7,** vorzugsweise aus Kunststoff, insbesondere aus PTFE oder Vespel, oder aus einer sub-Wellenlängen-Struktur, aufgebracht sein.

Der Mikrowellenspiegel 8a bei der ersten Ausführungsform der Erfindung gemäß Fig. 1a ist auf der dem Mikrowellenleiter 9 bezüglich des Probenvolumens 4 gegenüberliegenden Innenwand des MAS-Stators 1 starr aufgebracht, insbesondere aufgeklebt, aufgelötet oder aufgeschweißt.

Bei der in Fig. 1b dargestellten weiteren Ausführungsform der Erfindung ist der Mikrowellenspiegel 8b verstellbar, insbesondere verschiebbar, in die dem Mikrowellenleiter 9 bezüglich des Probenvolumens 4 gegenüberliegenden Innenwand des MAS-Stators 1 eingebracht.

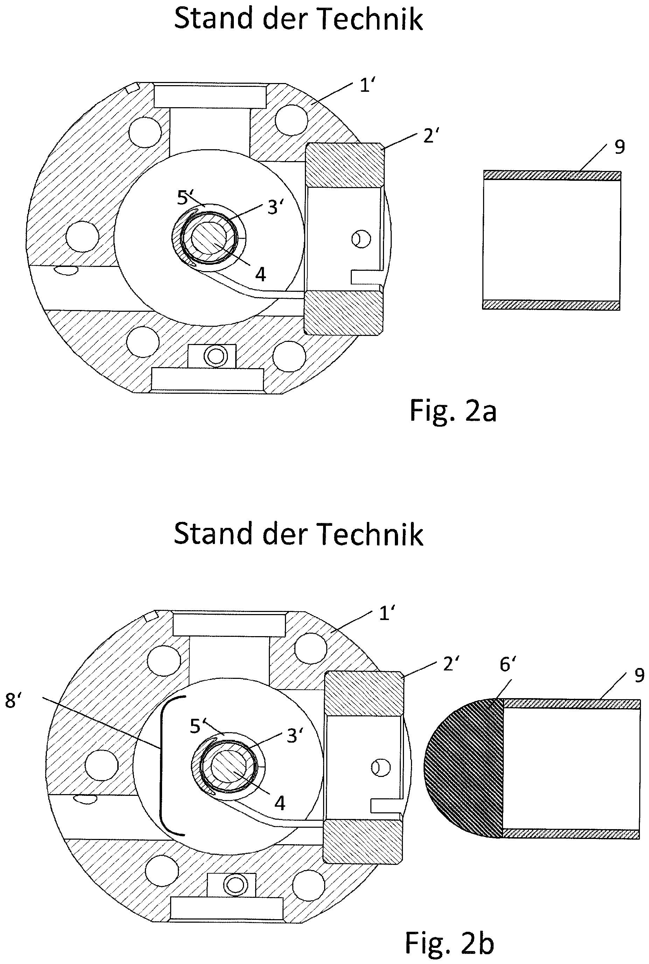

Zum besseren Verständnis soll im Folgenden die bisher übliche Technik erläutert werden, wie sie in den Figuren 2a und 2b dargestellt ist und die von der Erfindung nunmehr verbessert wird:
Auch bei den Anordnungen gemäß dem Stand der Technik ist jeweils einen **MAS-Stator 1',** ein **Spulenklotz 2',** ein **MAS-Rotor 3'** mit einer Probensubstanz im Probenvolumen 4, eine **HF-Spule 5'** sowie ein hohler **Mikrowellenleiter 9**' vorhanden. Die Anordnung in Fig. 2b umfasst darüber hinaus auch eine **Mikrowellenlinse 6'** sowie einen **Mikrowellenspiegel 8.**

Beim Stand der Technik nach Fig. 2a wird der einfallende Mikrowellenstrahl lediglich auf das Probenvolumen gerichtet; er wird abgesehen von der auf die Probe angepassten Größe in keiner Weise modifiziert. Beim Einfall auf Spule und Rotor geht ein signifikanter Anteil der Leistung durch Streuung, Beugung und Reflexion verloren. Die vorliegende Erfindung nutzt den Strahl geschickter, indem die Strahlcharakteristik weitgehend beibehalten wird und der Strahl durch Reflexion erneut durch die Probe geht.

Beim nächstliegenden Stand der Technik werden ebenfalls eine Linse und ein Spiegel verwendet, und eine mögliche Ausführung wird in Fig. 2b gezeigt. Allerdings ist nach Fig. 10C die Linse zumindest in der Richtung parallel zur Rotorachse sphärisch ausgeführt, während die vorliegende Erfindung eine in orthogonaler Richtung zur Rotorachse gekrümmte Linsenfläche beschreibt. Aus diesem nächstliegenden Stand der Technik wird daher nicht ersichtlich, in welcher Weise eine Berücksichtigung der zylindrischen Eigenschaft des Rotors erfolgt. Des Weiteren zeigt Fig. 10C Strukturen und Abstände, die nur wenig größer sind als eine Wellenlänge. In diesem Regime ist es deutlich einfacher, eine resonante Struktur zu erzeugen. Die vorliegende Erfindung optimiert den Stand der Technik für den Fall, bei dem die charakteristische Größe des Aufbaus mehrere (>10) Wellenlängen beträgt.

Die erfindungsgemäße Optimierung der Einstrahlung erfolgt durch die zylindrische Linse 6, um einen senkrechten Einstrahlwinkel auf den Rotor 3 zu erhalten, sowie zur Bündelung auf den Rotor. Bei einem senkrechten Einfall auf die Rotorwand wirkt die eigentlich gekrümmte Rotorwand wie eine Wand konstanter Dicke, die man auf maximale Transmission optimieren kann. Tut man dies nicht, dann trifft der Strahl je nach Abstand vom Zentrum in unterschiedlichem Winkel auf den Rotor, so dass der transmittierte Teil des Strahls positionsabhängig variiert und seine Intensität nicht gleichermaßen maximiert werden kann. Dies stellt insofern eine Abgrenzung dar zur naheliegenden Funktion der Linse, nämlich den Strahl auf die Probe zu fokussieren. Die Brennweite der Linse muss dem Abstand der Linse vom Rotor-/Spulenzentrum entsprechen.

Die Linse aus dielektrischem Material hat Abmessungen in derselben Größenordnung wie die Wellenlänge der eingebrachten mm-Welle. Dementsprechend hat die Dicke der Linse einen Einfluss auf die Intensität der transmittierten Welle. Dies liegt zum einen an der Dämpfung im Dielektrikum, wodurch die Transmission mit zunehmender Dicke stetig abnimmt. Bei verlustarmen Dielektrika wie z.B. Saphir kann dieser Anteil unter 1% liegen. Darüber hinaus zeigt die Transmission eine periodisch verlaufende Abhängigkeit von der Dicke. Dies ist begründet in der Interferenz der an den beiden Grenzflächen der Linse reflektierten sowie transmittierten Strahl-Anteilen. Näherungsweise soll davon ausgegangen werden, dass nur die Dicke der Linse im Mittelpunkt betrachtet wird, denn dort liegt auch das Maximum der Intensität des Gaußschen Strahls. Aufgrund von konstruktiver Interferenz ist die Transmission durch die Linse maximal, wenn ihre Dicke m·λₘ/2 beträgt, wobei m eine ganze Zahl >1 sein soll und λₘ=λ₀/√(εᵣ) die Wellenläge im Dielektrikum, bestimmt durch die Wellenlänge im Vakuum geteilt durch die Wurzel aus der relativen Dielektrizitätszahl des Linsenmaterials. Die Minima der Transmission ergeben sich für Linsen der Dicke (2m+1)·λₘ/4. Dies ist besonders relevant wenn die Linse ohne Antireflexschicht benutzt wird. Benutzt man Antireflexschichten auf beiden Seiten der Linse wird die Transmission weitgehend unabhängig von der Linsendicke.

Wesentlich für die vorliegende Erfindung ist weiter eine in Drahtdurchmesser und Windungsabstand derart angepasste Spule, dass der transmittierte Strahl möglichst wenig beeinflusst wird (T>80%). Die Spulenwicklung wirkt ähnlich wie ein Polarisationsfilter: In Abhängigkeit von der Dicke des Drahtes und dem Abstand D zwischen den einzelnen Wicklungen kann die Transmission für eine bestimmte Wellenlänge optimiert werden. Jedoch ist bereits für planare Gitter die Abhängigkeit nichtlinear und analytisch nur mit sehr hohem Aufwand beschreibbar. Dieser Zusammenhang wurde in der wissenschaftlichen Literatur beschrieben.

Wichtig für die Erfindung ist auch ein zylindrischer Spiegel an der Rückwand des Stators, um den Strahl unter Erhaltung der Gauß-Charakteristik zurück in die Probe zu lenken. Vorzugsweise ist der Abstand des Spiegels einstellbar, da sich die Wellenlänge beim Durchgang durch die Probe ändert aufgrund der unterschiedlichen Dielektrizitätskonstanten des Materials. Die reflektierte Welle soll die kommende nicht auslöschen. Dadurch wird die ursprünglich eher unkontrollierte Einstrahlung zu einer kontrollierter Einstrahlung mit zwei Durchgängen. EM-Simulationen zeigen, dass dadurch die Leistung um einen Faktor 2-4 reduzierbar ist, erste Experimente zeigten eine Reduktion von 2-3. Simulationen zeigen außerdem, dass im optimierten Setup gut 30% der eingebrachten Leistung in der Probe dissipiert werden. Beim nächstkommenden Stand der Technik liegt dieser Wert bei etwa 10%. Durch die höhere Effizienz wird das erreichbare DNP-Enhancement auch mit schwächeren Quellen als Gyrotron (z.B. Klystron) gesteigert.

Das modifizierte Setup liefert unterschiedliche Effizienzsteigerung je nach Eigenschaft der Probe, da eine Abhängigkeit von der komplexen dielektrischen Konstante besteht. Simulationen zeigen, dass hier im ungünstigsten Fall ein Rückfall auf den Wert erfolgt, der auch ohne einen Spiegel erzielt würde. Abhilfe kann hier die Verschiebung des Spiegels im Bereich von λ/2 auf der Strahlachse schaffen.

### Ausführunctsbeispiel:

Bei 263 GHz ist vorgesehen, einen 3.2mm Rotor aus Saphir mit Innendurchmesser 2.1 mm zu verwenden. Die Spule ist gewickelt aus Draht mit einem Durchmesser von 0.3mm, 7.5 Windungen und einem Windungsabstand von etwa 1 mm (Mittelpunkt zu Mittelpunkt). Die Mikrowellenlinse 6 ist zylindrisch plan-konvex ausgeführt, besteht aus Saphir, hat einen Krümmungsradius von 11.5mm und eine Dicke von ca. 1.5mm. Einseitig ist eine Antireflexschicht aus Teflon (PTFE) vorhanden mit einer Dicke von 0,20mm, die gleichzeitig auch dafür sorgt, dass die Linse nicht aus dem Spulenklotz 2 fällt. Der Mikrowellenspiegel 8 ist als 70µm dicke Kupferfolie ausgeführt, die auf die Rückwand des Stators geklebt wurde. Der Abstand des Spiegels zum Rotormittelpunkt beträgt in diesem Beispiel 6mm.

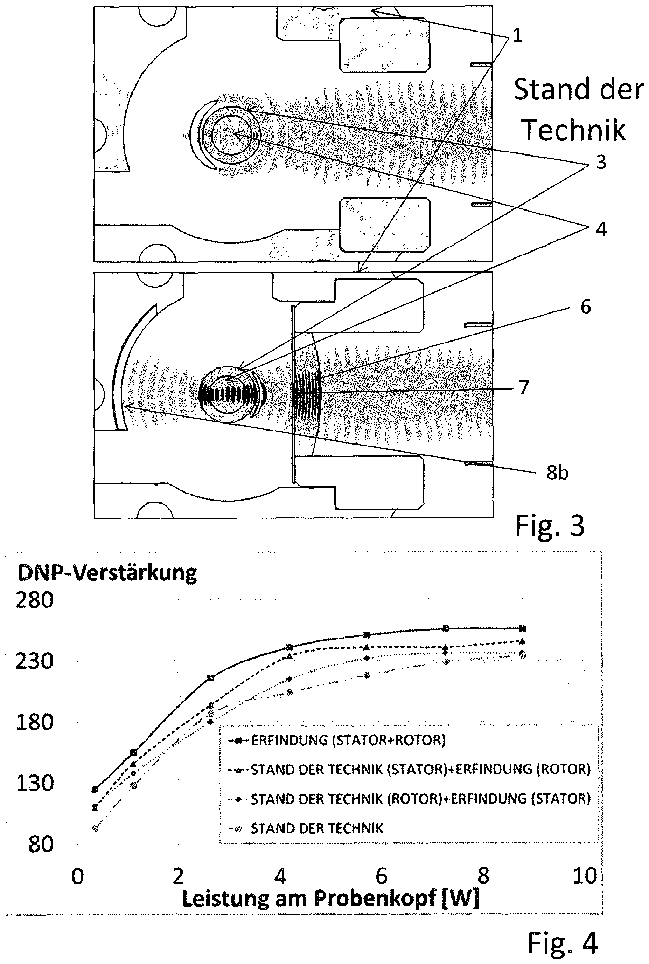

Fig. 3 stellt eine 3D EM-Simulation der H-Feld Amplitude bei einer Anordnung nach dem nächstliegenden Stand der Technik (oben) und einer erfindungsgemäßen Anordnung (unten) dar. Damit wird der technische Fortschritt aufgrund der vorliegenden Erfindung deutlich veranschaulicht:

### Bisheriger Fall (Stand der Technik, oben):

Der Gaußsche Strahl kommt von rechts und trifft auf Spule und Rotor; die Ausleuchtung ist zwar recht gut, aber nach dem ersten Auftreffen wird der Strahl unkontrolliert reflektiert und gebeugt, wodurch ein beträchtlicher Teil verloren geht.

### Erfindung (unten):

Der Gaußsche Strahl kommt von rechts, trifft auf die zylindrische Linse und wird in einer Richtung gebündelt, so dass er nahezu senkrecht auf den Rotor trifft. Dadurch lässt sich die Rotorwand einheitlich anpassen, da der Rotor dann nicht wie eine gekrümmte Fläche wirkt, sondern wie ein planares Dielektrikum. Die Spule transmittiert den Strahl weitgehend ungehindert, so dass dieser am zylindrischen Spiegel reflektiert wird und erneut durch die Probe dringt. Durch den zweifachen Durchgang erhöht sich die aufgenommene Leistung in der Probe.

Der Effizienzgewinn aufgrund der Erfindung ist beispielhaft in Fig. 4 grafisch abgebildet. Aus den in Fig. 4 zusammengestellten experimentellen Daten ist zu erkennen, wie der erfindungsgemäße Stator bzw. der erfindungsgemäße Rotor in unterschiedlichen Kombinationen mit einem bisher verwendeten Standardrotor bzw. -Stator hinsichtlich der Polarisierungszugewinns (DNP gain) als Funktion der eingestrahlten Mikrowellenleistung verhält. Hier ist deutlich zu erkennen, dass bereits der Stator alleine den "DNP gain" verbessert. Die Kombination von erfindungsgemäßem Stator und Rotor führt dazu, dass man den gleichen Polarisierungseffekt schon bei deutlich niedrigerer Mikrowellenleistung erhält (3,6W statt 8,7W). Als Folge kann man also auf kleinere und kostengünstigere Mikrowellenquellen zurückgreifen. Ist die bereitgestellte Leistung nicht begrenzt, so lässt sich in Sättigung unter Umständen auch ein höherer DNP gain erreichen.

### Bezugszeichenliste

- 1; 1': MAS-Stator
- 2; 2': Spulenklotz
- 3; 3': MAS-Rotor
- 4: Probenvolumen
- 5; 5': HF-Spule
- 6; 6': Mikrowellenlinse
- 7: Anti-Reflexionsschicht
- 8a; 8b; 8': Mikrowellenspiegel
- 9: Mikrowellenleiter

## Patentansprüche

1. MAS-Stator (1) eines NMR-Probenkopfes zur Aufnahme eines im Wesentlichen kreiszylindrischen hohlen MAS-Rotors (3) mit einer Probensubstanz in einem Probenvolumen (4), welcher in einer Messposition innerhalb des MAS-Stators (1) mittels einer Einrichtung zur Gaszufuhr druckgasgelagert sowie mittels eines pneumatischen Antriebs in Rotation um die Zylinderachse des MAS-Rotors (3) versetzt werden kann, wobei ein hohler Mikrowellenleiter (9) zur Zuführung von Mikrowellenstrahlung durch eine Öffnung in einem in die Wand des MAS-Stators (1) eingeführten Spulenklotzes (2) in das Probenvolumen (4) vorgesehen ist, wobei zwischen dem Mikrowellenleiter (9) und dem Probenvolumen (4) eine Mikrowellenlinse (6) zur Bündelung der zugeführten Mikrowellenstrahlung auf den MAS-Rotor (3) angeordnet ist, wobei der MAS-Rotor (3) von einer solenoidförmigen HF-Spule (5) umgeben ist, und wobei auf der dem Mikrowellenleiter (9) gegenüberliegenden Innenseite des MAS-Stators (1) ein Mikrowellenspiegel (8a; 8b) zur Reflexion der aus dem Mikrowellenleiter (9) austretenden und durch das Probenvolumen (4) hindurchtretenden Mikrowellenstrahlung vorhanden ist,
**dadurch gekennzeichnet,**
**dass** die Mikrowellenlinse (6) in der Öffnung des Spulenklotzes (2) auf der dem Probenvolumen (4) zugewandten Seite derart angeordnet und hinsichtlich ihrer Brennweite geometrisch so ausgebildet ist, dass die Zylinderachse des MAS-Rotors (3) im Brennpunkt der Mikrowellenlinse (6) liegt,
**dass** die HF-Spule (5) eine aus mehreren voneinander beabstandeten Windungen aufgebaute einlagige Solenoidspule ist, deren Windungsdrahtdicke d und Windungsabstand D so optimiert sind, dass die Mikrowellenstrahlung durch die HF-Spule (5) zu mindestens 80% transmittiert wird, wobei das Verhältnis von d zu D gleich oder kleiner als 0,5 und das Verhältnis von D zur Wellenlänge der Mikrowellenstrahlung im Vakuum größer als 0,5 ist,
**dass** der Mikrowellenspiegel (8a; 8b) auf oder in der dem Mikrowellenleiter (9) bezüglich des Probenvolumens (4) gegenüberliegenden Innenwand des MAS-Stators (1) angeordnet und zylindrisch sowie in Richtung auf das Probenvolumen (4) konkav aufgebaut ist,
und **dass** der Mikrowellenspiegel (8a; 8b) konstruktiv derart ausgestaltet ist, dass er die vom Probenvolumen (4) kommend auf ihn auftreffende Mikrowellenstrahlung auf die Mittelachse des kreiszylindrischen MAS-Rotors (3) fokussiert.

2. MAS-Stator nach Anspruch 1, **dadurch gekennzeichnet, dass** die Mikrowellenlinse (6) geometrisch so ausgebildet ist, dass ihre Dicke auf ihrer Mittelachse ein ganzzahliges Vielfaches der halben Wellenlänge der transmittierten Mikrowellenstrahlung im Dielektrikum des Mikrowellenleiters (9) beträgt, so dass die aus dem Mikrowellenleiter (9) ankommende Mikrowellenstrahlung maximal in Richtung auf das Probenvolumen (4) transmittiert wird.

3. MAS-Stator nach Anspruch 1 oder 2, **dadurch gekennzeichnet, dass** die Mikrowellenlinse (6) in Strahlungsrichtung der aus dem Mikrowellenleiter (9) in Richtung auf das Probenvolumen (4) austretenden Mikrowellenstrahlung gesehen konvex-plan ausgeführt ist und insbesondere auf ihrer Mittelachse eine Dicke zwischen 1 mm und 2mm, vorzugsweise etwa 1,5mm, aufweist.

4. MAS-Stator nach einem der vorhergehenden Ansprüche, **dadurch gekennzeichnet, dass** die Mikrowellenlinse (6) mindestens eine zylindrische Fläche, insbesondere mit einem Krümmungsradius zwischen 8mm und 15mm, vorzugsweise etwa 11,5mm, aufweist.

5. MAS-Stator nach einem der vorhergehenden Ansprüche, **dadurch gekennzeichnet, dass** die Mikrowellenlinse (6) aus dielektrischem Material, vorzugsweise aus Saphir und/oder Silizium und/oder Bornitrid aufgebaut ist.

6. MAS-Stator nach einem der vorhergehenden Ansprüche, **dadurch gekennzeichnet, dass** auf den äußeren Oberflächen der Mikrowellenlinse (6) eine Anti-Reflexionsschicht (7), vorzugsweise aus Kunststoff, insbesondere aus PTFE oder Vespel, oder aus einer sub-Wellenlängen-Struktur, aufgebracht ist.

7. MAS-Stator nach einem der vorhergehenden Ansprüche, **dadurch gekennzeichnet, dass** die HF-Spule (5) aus einem magnetisch kompensierten Draht oder aus Cu und/oder Ag und/oder Al beziehungsweise deren Legierungen aufgebaut ist.

8. MAS-Stator nach einem der vorhergehenden Ansprüche, **dadurch gekennzeichnet, dass** die HF-Spule (5) mit einer Windungsdrahtdicke d von 0,2mm bis 0,5mm, insbesondere d ∼ 0,3mm, mit 5 bis 10 Windungen, insbesondere 7,5 Windungen, und mit einem Windungsabstand D von 0,7mm bis 2mm, insbesondere D ∼ 1 mm, aufgebaut ist.

9. MAS-Stator nach einem der vorhergehenden Ansprüche, **dadurch gekennzeichnet, dass** der Mikrowellenspiegel (8a; 8b) aus Ag, Au oder Cu-Blech aufgebaut ist, welches vorzugsweise eine Dicke zwischen 1µm und 100µm, insbesondere etwa 70µm, aufweist.

10. MAS-Stator nach einem der Ansprüche 1 bis 9, **dadurch gekennzeichnet, dass** der Mikrowellenspiegel (8a) auf der dem Mikrowellenleiter (9) bezüglich des Probenvolumens (4) gegenüberliegenden Innenwand des MAS-Stators (1) starr aufgebracht, insbesondere aufgeklebt, aufgelötet oder aufgeschweißt ist.

11. MAS-Stator nach einem der Ansprüche 1 bis 9, **dadurch gekennzeichnet, dass** der Mikrowellenspiegel (8b) verstellbar, insbesondere verschiebbar, in die dem Mikrowellenleiter (9) bezüglich des Probenvolumens (4) gegenüberliegenden Innenwand des MAS-Stators (1) eingebracht ist.

12. Probenkopf mit einem MAS-Stator (1) nach einem der vorhergehenden Ansprüche, **dadurch gekennzeichnet, dass** ein pneumatisches Probenwechselsystem zum Zuführen und Abführen eines MAS-Rotors (3) zum MAS-Stator (1) vorgesehen ist.

13. Probenkopf nach Anspruch 12, **dadurch gekennzeichnet, dass** der MAS-Rotor (3) einen Durchmesser von 0,7mm bis 4mm, vorzugsweise von 1,3mm bis 3,2mm, aufweist.

14. Probenkopf nach Anspruch 12 oder 13, **dadurch gekennzeichnet, dass** der hohle MAS-Rotor (3) geometrisch so ausgebildet ist, dass seine Wanddicke einem ganzzahligen Vielfachen der halben Wellenlänge der transmittierten Mikrowellenstrahlung im Dielektrikum der Rotorwand entspricht, so dass die aus der Mikrowellenlinse (6) ankommende Mikrowellenstrahlung maximal in Richtung auf das Probenvolumen (4), aus dem Probenvolumen heraus und auf den Mikrowellenspiegel (8a; 8b) transmittiert.

15. Probenkopf nach einem der Ansprüche 12 bis 14, **dadurch gekennzeichnet, dass** der MAS-Rotor (3) aus Saphir, tetragonal stabilisiertem Zirkonoxid und/oder Siliziumnitrid, mit einer Wanddicke zwischen 0,2mm bis 0,7mm, vorzugsweise etwa 0,55mm, sowie mit einem Durchmesser kleiner 4mm, insbesondere etwa 3,2mm, etwa 1,9mm oder etwa 1,3mm, aufgebaut ist.
